# FASCICULE DE BREVET EUROPEEN

(11) **EP 1 599 906 B1**
(45) Date de publication et mention de la délivrance du brevet: **16.01.2019**
(21) Numéro de dépôt: 04716637.6
(22) Date de dépôt: 03.03.2004
(51) Int. Cl.: H01L 27/146, H01L 31/0224

(54) **MATRICE DE PIXELS DETECTEURS INTEGREE SUR CIRCUIT DE LECTURE DE CHARGES**
AUF EINE LADUNGSLESESCHALTUNG INTEGRIERTE DETEKTIONSPIXELMATRIX
DETECTING PIXEL MATRIX INTEGRATED OVER A CHARGE READING CIRCUIT

(30) Priorité: 06.03.2003 FR 0302782
(43) Date de publication de la demande: 30.11.2005
(73) Titulaire: Commissariat à l'Énergie Atomique et aux Énergies Alternatives, 75015 Paris (FR)
(72) Inventeur: GUEDJ, Cyril, F-38760 Varces Allières et Risset (FR); MOUSSY, Norbert, F-38190 Sainte-Agnes (FR)
(74) Mandataire: Ahner, Philippe
(86) Numéro de dépôt international: PCT/FR2004/050091
(87) Numéro de publication internationale: WO 2004/081517

(56) Documents cités:
- EP-A- 0 555 907
- EP-A- 1 122 790
- US-A- 4 651 180
- US-A- 5 236 871
- US-A- 5 602 392
- US-B1- 6 215 164
- US-B1- 6 399 967

## Description

### Domaine de la technique et art antérieur

L'invention concerne une matrice de pixels détecteurs ainsi qu'un détecteur photoélectrique comprenant une matrice de pixels détecteurs et un circuit de lecture des charges générées par les pixels détecteurs de la matrice.

L'invention concerne également un procédé de fabrication de matrice de pixels détecteurs ainsi qu'un procédé de fabrication de détecteur photoélectrique comprenant une matrice de pixels détecteurs et un circuit de lecture des charges générées par les pixels détecteurs de la matrice.

L'invention s'applique, par exemple, à la réalisation de capteurs utilisés dans les scanners, les appareils photographiques et les caméras numériques, ainsi que dans les biopuces, notamment pour le séquençage de l'ADN.

Un détecteur photoélectrique selon l'invention permet de réaliser, par exemple, un imageur anti-éblouissement intégré monolithiquement à la surface d'un circuit de lecture de technologie CMOS (CMOS pour « Complementary Metal-Oxyde Semi-conductor »).

Les technologies actuelles de fabrication d'imageurs déposés monolithiquement sur circuit de lecture CMOS consistent à déposer des couches successives de type NIP, IP, PIN ou IN sur les plots du circuit de lecture. Une couche d'oxyde transparent conducteur reliée à tous les pixels est ensuite déposée pour former une électrode supérieure qui descend latéralement sur la périphérie de la matrice de photodiodes.

Cette technique permet de réaliser des imageurs de manière collective et monolithique, sans avoir à effectuer de soudure additionnelle pour relier le contact supérieur au circuit de lecture CMOS. Il en résulte un gain de temps, des coûts moindres et une fiabilité accrue des composants.

Un inconvénient réside cependant dans la présence de fuites latérales de charges ou de photons entre les pixels. Ce phénomène de fuites latérales de charges ou de photons entre pixels est connu sous le nom d'intermodulation. Plusieurs techniques sont connues pour diminuer l'intermodulation.

Une première technique consiste à séparer les pixels les uns des autres par des zones isolantes, comme décrit dans le brevet US 6 215 164. Cette technique est représentée en figure 1. Un substrat 1 est recouvert d'une structure d'interconnexion 2 dans laquelle sont formées des connexions conductrices 3a, 3b, 3c, 3d. Une pluralité de pixels détecteurs sont formés en surface de la structure d'interconnexion 2. Chaque pixel détecteur comprend une zone semi-conductrice intrinsèque 6 entourée de deux électrodes. Une première électrode 5 est reliée, par l'intermédiaire d'un plot métallique 4, à une connexion conductrice formée dans la structure 2. Des régions diélectriques isolantes 7 séparent les zones semi-conductrices intrinsèques 6 les unes des autres. Une couche 8 dopée P recouvre l'ensemble des zones semi-conductrices 6 et des régions diélectriques isolantes 7. Une couche conductrice transparente 9 recouvre la couche 8 et constitue la deuxième électrode pour l'ensemble des pixels détecteurs. La couche conductrice 9 est électriquement reliée au substrat par l'intermédiaire de l'une des connexions conductrices formées dans la structure d'interconnexion 2.

Les régions diélectriques 7 permettent avantageusement d'isoler les pixels détecteurs les uns des autres. La présence des régions diélectriques 7 est cependant une source d'inconvénients. Il existe en effet des risques élevés de fuite à l'interface entre les zones semi-conductrices 6 et les régions diélectriques isolantes 7. En effet, dans le volume d'un diélectrique isolant, les atomes sont liés à leurs voisins de manière homogène, contrairement à ce qui se passe en surface où certains des atomes présentent des liaisons atomiques déformées. Une déformation de certaines liaisons atomiques est ainsi présente à l'interface des régions diélectriques isolantes 7 et des zones semi-conductrices 6. Il se crée alors des centres de défauts potentiellement conducteurs.

Par ailleurs, la couche conductrice transparente 9 qui recouvre totalement la couche photosensible absorbe partiellement la lumière reçue, diminuant ainsi la quantité de photons détectés. De plus, la couche conductrice transparente 9 est généralement une couche d'oxyde. Or, les propriétés des oxydes transparents conducteurs évoluent dans le temps et leur fabrication n'est pas toujours simple et reproductible. Cela représente un autre inconvénient.

Une deuxième technique consiste à réaliser des caches optiques pour empêcher la lumière d'atteindre les zones situées entre les électrodes. Cette technique, divulguée dans le brevet EP 1 122 790, est représentée en figure 2. Un substrat 10 est recouvert d'une structure d'interconnexion 11 dans laquelle sont formées des connexions conductrices 12a, 12b, 12c, 12d. Une pluralité de pixels détecteurs sont formés en surface de la structure d'interconnexion 11. Chaque pixel détecteur comprend une zone semi-conductrice intrinsèque entourée de deux électrodes. Une première électrode 13 est reliée à une connexion métallique formée dans le substrat 11. Une couche de semi-conducteur intrinsèque 14 recouvre le substrat 11 et les plots métalliques 13 de sorte que les fractions de couche 14 qui recouvrent les électrodes 13 constituent les zones semi-conductrices des pixels détecteurs. Une couche 15 de semi-conducteur dopée P recouvre la couche 14 et constitue une deuxième électrode pour l'ensemble des pixels détecteurs.

Une couche conductrice non transparente 16 recouvre la couche 15. La couche conductrice non transparente 16 comprend des ouvertures 17 positionnées à la verticale des pixels détecteurs afin de laisser passer les photons. Des zones non transparentes 18 séparent les ouvertures 17 et constituent des caches optiques qui masquent les zones photosensibles situées entre deux pixels voisins. La présence des caches optiques conduit à diminuer très sensiblement la quantité de photons détectés. Le facteur de remplissage de l'imageur s'en trouve fortement diminué. En outre, les caches optiques n'empêchent pas les charges électriques de circuler, malgré tout, entre pixels voisins par l'intermédiaire de la couche de semi-conducteur intrinsèque 14. Cette technique diminue donc l'intermodulation optique mais pas l'intermodulation électrique.

De façon générale, l'intermodulation est, à l'heure actuelle, un problème de plus en plus critique du fait de la diminution de la taille des pixels. En effet, les distances entre pixels deviennent à l'heure actuelle comparables au libre parcours moyen des électrons dans les régions photosensibles (typiquement de l'ordre du micromètre). Pour s'affranchir des problèmes induits par une telle proximité, il est souvent nécessaire de concevoir des circuits de lectures spécialement adaptés. Cela représente un autre inconvénient.

L'invention ne présente pas les inconvénients mentionnés ci-dessus.

Sont également connus dans l'art antérieur :
- la demande de brevet EP 0 555 907 qui divulgue un procédé de fabrication de matrice de pixels détecteurs de grandes dimensions,
- le brevet US 5 602 392 qui divulgue un imageur thermique à pixels détecteurs,
- le brevet US 5 236 871 qui divulgue un procédé de fabrication de matrice de détecteurs dans une couche de matériau semi-conducteur, et
- le brevet US 4 651 180 qui divulgue un transducteur photoélectrique à semi-conducteur à haute sensibilité de détection.

### Exposé de l'invention

L'invention concerne :
- une matrice de pixels détecteurs conforme à la revendication 1,
- un détecteur photoélectrique conforme à la revendication 13,
- un procédé de fabrication de matrice de pixels détecteurs conforme à la revendication.

Des caractéristiques supplémentaires de l'invention sont contenues dans les revendications dépendentes.

Un dispositif photoélectrique selon l'invention est une structure anti-éblouissement à très faible intermodulation qui permet d'adresser chaque pixel ou bloc de pixels individuellement. En outre, le matériau choisi selon le mode de réalisation préférentiel de l'invention permet de fortement diminuer le vieillissement et d'augmenter les performances dynamiques. Les diodes obtenues sont plus rapides, beaucoup plus stables dans le temps, et résistent aux forts éblouissements locaux. Il en résulte une nette amélioration des performances. Par ailleurs, le procédé de fabrication de la structure est simple et robuste.

Le motif métallique formé à la surface d'un pixel détecteur est conçu pour collecter sensiblement la totalité des porteurs créés dans le volume du pixel. Avantageusement, la totalité de la zone semi-conductrice photosensible d'un pixel détecteur constitue alors sensiblement une zone de collecte pour l'ensemble des porteurs générés dans la zone semi-conductrice photosensible. Par zone de collecte des porteurs, il faut entendre une zone dans laquelle tout porteur généré est quasiment sûr d'être collecté par l'électrode, la probabilité pour collecter les porteurs générés au-delà de cette zone étant quasiment nulle.

Selon l'invention, les lignes de champ électrique sont concentrées vers le centre du pixel, permettant ainsi un drainage des porteurs détectés vers le centre du pixel. Il est alors possible d'éviter une éventuelle dispersion latérale des porteurs détectés.

La présente invention permet de réticuler chaque pixel détecteur. La réticulation empêche ainsi, par exemple, les charges en excès d'atteindre les pixels voisins. La définition de l'image s'en trouve améliorée. Le motif métallique d'électrode supérieure constitue une ligne équipotentielle qui collecte efficacement les porteurs. En outre, il est également possible d'adresser individuellement chaque pixel, puisque l'électrode supérieure n'est pas nécessairement commune. Trois sous-réseaux de pixels pour les couleurs respectives Rouge, Vert, Bleu peuvent ainsi être constitués. En outre, l'utilisation du silicium polymorphe pour constituer le matériau photosensible permet d'augmenter fortement la stabilité dans le temps, la vitesse et le rendement de conversion photoélectrique. Ce matériau résiste particulièrement bien aux forts éclairements et présente une densité d'état si faible que la dynamique en régime impulsionnel s'en trouve notablement améliorée. La rémanence obtenue avec un tel matériau est inférieure à celle obtenue avec un matériau standard, ce qui permet des fonctionnements à des cadences très élevées. La technologie mise en oeuvre selon le mode de réalisation préférentiel de l'invention est donc compatible avec une grande variété de circuits de lecture CMOS existants, analogiques ou numériques.

L'invention permet avantageusement d'éviter l'éblouissement des pixels et d'obtenir des imageurs rapides, très stables dans le temps et qui résistent à de forts éclairements (explosions, forts grossissements, focalisation importante...). Chaque pixel- pouvant être individualisé, il est possible d'effectuer des corrections sur les pixels défectueux pour homogénéiser l'image à très faible éclairement. Il est également possible d'effectuer des traitements d'image intégrés à l'imageur (rétines intelligentes) et/ou toute opération nécessitant d'accéder individuellement aux deux électrodes de chaque photodiode.

L'invention trouve une application particulièrement avantageuse pour réaliser des pixels de l'ordre de quelques microns de diamètre, car la longueur de diffusion des porteurs photogénérés dans un pixel est alors telle que ces derniers atteignent très facilement le motif métallique de l'électrode supérieure. C'est un des aspects les plus originaux de l'invention.

Un autre avantage de l'invention par rapport aux technologies antérieures est la plus grande simplicité de réalisation. En effet, selon l'invention, il est possible de s'affranchir de l'utilisation d'oxyde transparent conducteur et l'électrode supérieure peut avantageusement être exclusivement constituée de métal classiquement utilisé en technologie CMOS.

### Brève description des figures

D'autres caractéristiques et avantages de l'invention apparaîtront à la lecture d'un mode de réalisation préférentiel de l'invention, parmi lesquelles :

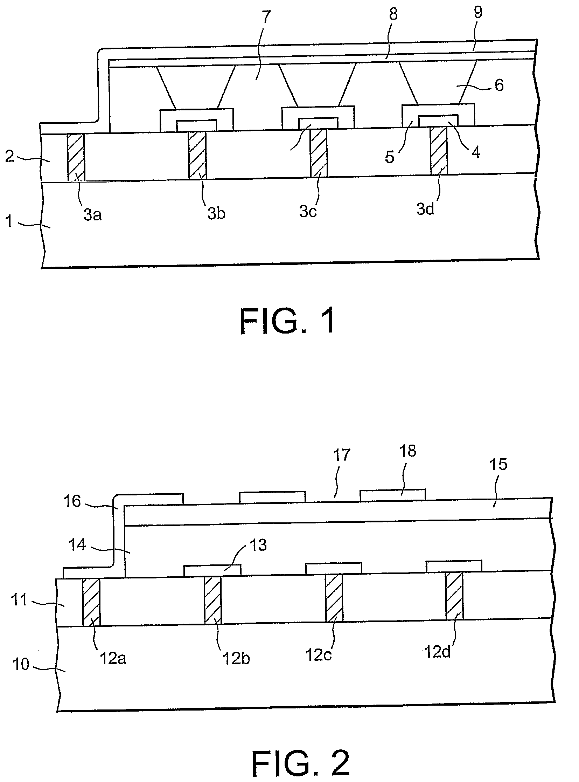

- la figure 1 représente un premier exemple d'imageur selon l'art antérieur ;
- la figure 2 représente un deuxième exemple d'imageur selon l'art antérieur ;
- la figure 3 représente la vue en coupe d'un imageur selon l'invention ;
- les figures 4A et 4B représentent, respectivement, la vue en perspective et la vue de dessus d'un premier exemple de pixel d'imageur selon l'invention ;
- la figure 5 représente une vue de dessus d'une association de pixels d'imageur selon l'exemple des figures 4A et 4B ;
- les figures 6A et 6B représentent, respectivement, une vue de dessus et une vue partielle en coupe d'un groupement de pixels d'imageur associés selon l'exemple de la figure 5 ;
- les figures 7A-7E représentent des vues de dessus d'associations de pixels présentant différentes géométries d'électrodes.
- les figures 8A-8D représentent des étapes d'un procédé de fabrication de détecteur photoélectrique selon l'invention ;
- la figure 9 représente un mode de réalisation particulier de l'invention.

Sur toutes les figures, les mêmes repères désignent les mêmes éléments.

### Description détaillée de modes de réalisation de l'invention

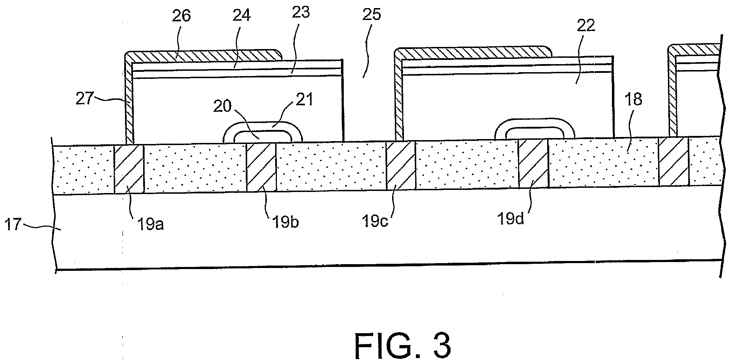

La figure 3 représente la vue en coupe d'un imageur selon l'invention.

Sur un substrat 17 pouvant être, par exemple, un circuit de lecture de type CMOS, est déposée une couche diélectrique 18 dans laquelle sont formées des connexions électriques 19a, 19b, 19c, 19d. Les connexions électriques 19a, 19b, 19c, 19d sont reliées à des plots conducteurs du circuit de lecture (non représentés sur la figure 3). Une pluralité de pixels détecteurs sont formés en surface de la couche diélectrique 18. Chaque pixel détecteur comprend une zone semi-conductrice photosensible 22 entourée de deux électrodes. Une région de barrière de diffusion 20 électriquement conductrice (par exemple une couche de TiN) et un contact conducteur 21 (par exemple une couche de semi-conducteur dopé n) constituent une première électrode réalisée au contact d'une connexion électrique (19b, 19d) insérée dans la couche diélectrique. La zone semi-conductrice 22 est une région photosensible réalisée, par exemple, en silicium amorphe non dopé ou en silicium polymorphe non dopé. De façon préférentielle, mais non obligatoire, la région photosensible 22 est recouverte d'une barrière de diffusion électriquement conductrice et transparente 23 (par exemple en silicium carboné hydrogéné) et d'une couche 24 de semi-conducteur dopée P déposée sur la barrière de diffusion 23. La couche 24 déposée, par exemple, selon la technique PECVD (PECVD pour « Plasma Enhanced Chemical Vapor Déposition ») à partir de la décomposition de triméthylborane (CH₃)3-Si assistée par plasma. Un motif métallique 26 recouvre la surface de la couche 24 et constitue la deuxième électrode du pixel détecteur.

Le motif 26 peut être réalisé, par exemple, en Al, Cu, Cr, Ni, W, Ti, TiW, Mo, Ln, Pt, Pd, Au, TiN, ou par des alliages ou des combinaisons de métaux optimisés pour leur conductivité. Pour chaque pixel, l'électrode 26 est prolongée par une liaison conductrice latérale 27 reliée à une connexion métallique 19a, 19c formée dans la couche diélectrique 18.

Selon l'invention, les pixels sont séparés les uns des autres par des tranchées étroites 25, comme cela est représenté sur la figure 3.

Avantageusement, l'imageur selon l'invention ne comprend pas de diélectrique entre les pixels et, partant, il n'est pas possible que s'établissent des courants de fuite tels que ceux mentionnés précédemment. Par ailleurs, le matériau photosensible est préférentiellement du silicium amorphe ou polymorphe pour gagner en stabilité et en vitesse de fonctionnement.

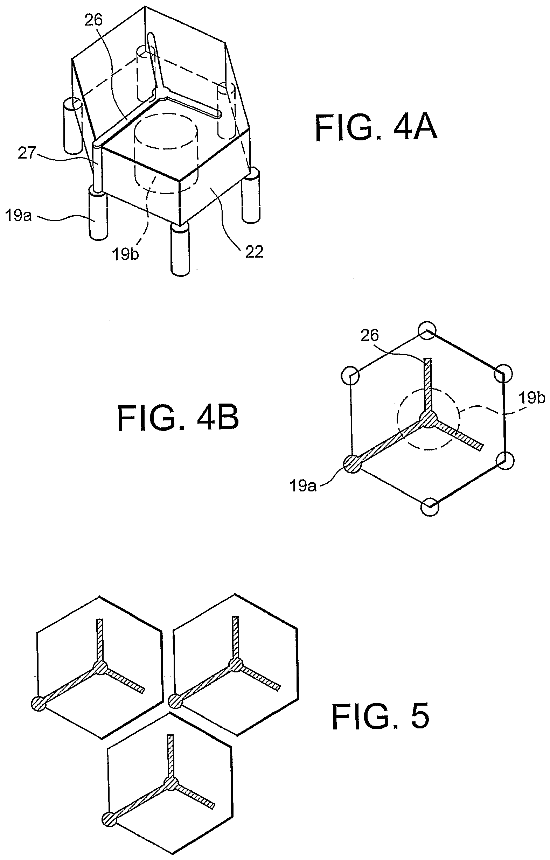

Les figures 4A et 4B représentent, respectivement, la vue en perspective et la vue de dessus d'un premier exemple de pixel d'imageur selon l'invention ;
Selon l'exemple des figures 4A et 4B, le pixel est de forme hexagonale et l'électrode 26 qui recouvre la couche 24 est en forme d'étoile à trois branches à 120° l'une de l'autre. Deux branches ne se prolongent que partiellement à la surface de la couche 24, alors que la troisième se prolonge sur toute la surface pour rejoindre la liaison conductrice latérale 27 qui est reliée à la connexion métallique 19a présente dans la couche diélectrique 18 (non représentée sur les figures 4A-4B). L'électrode 26 collecte les porteurs. La forme en étoile de l'électrode 26 permet avantageusement de concentrer les lignes de champ vers le centre du pixel et, partant, d'éviter la dispersion latérale des charges. En outre, la faible résistance électrique du contact entre la couche 24 dopée P et l'électrode 26 permet d'obtenir un détecteur ayant de très bonnes performances en vitesse de réponse et en bruit. Par ailleurs, les métaux utilisables pour réaliser les contacts électriques (électrodes, connexions de substrat, etc.) sont parfaitement compatibles avec les technologies CMOS standards. Il est ainsi possible, par exemple, d'utiliser une électrode de connexion électrique en aluminium, ou en nitrure de titane, ou en tungstène, ou en nitrure de tungstène.

Les branches qui composent l'électrode 26 sont, préférentiellement, réalisées par des pistes très • fines, par exemple inférieures à 0,3 µm, voire moins. Il s'en suit que l'électrode 26 ne recouvre qu'une très petite surface de la couche 24, n'empêchant ainsi qu'une très faible quantité de lumière de pénétrer dans la zone active.

La figure 5 représente une vue de dessus d'une association de pixels d'imageur tels que représentés aux figures 4A et 4B. L'association de pixels présente une configuration en nid d'abeille. Un telle configuration est retenue, entre autres, parce qu'elle permet d'éviter les angles trop aigus qui induisent des renforcements locaux du champ électrique. Les trois pixels représentés correspondent, par exemple, aux 3 couleurs de base, Rouge (R), Vert (G) et Bleu (B). Le point de raccordement d'une électrode supérieure avec le circuit de lecture est situé au coin de l'hexagone. D'autres configurations sont cependant possibles, car, de façon plus générale, la position du point de raccordement est en fait choisie en fonction du circuit de lecture qui se trouve sous la couche diélectrique.

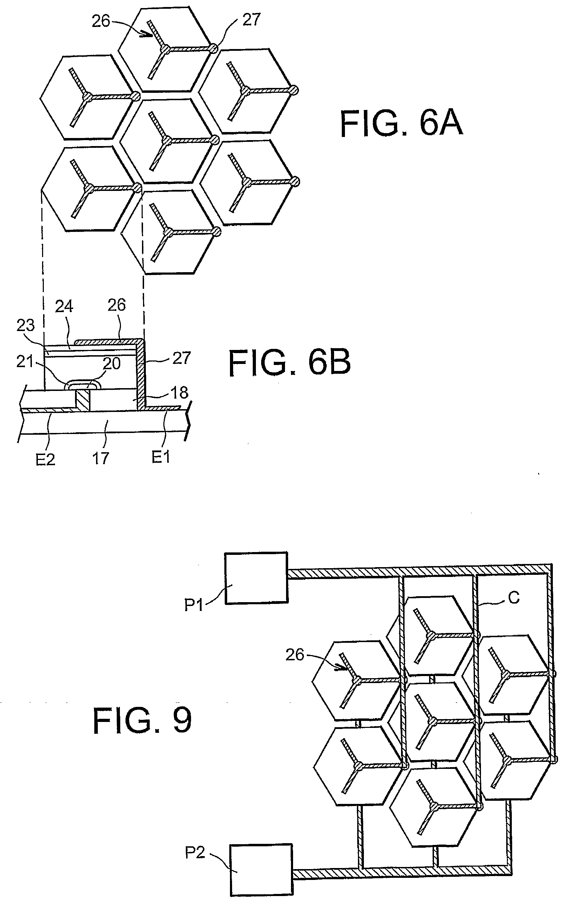

Les figures 6A et 6B représentent, respectivement, une vue de dessus et une vue partielle en coupe d'un groupement de pixels d'imageur associés selon l'exemple de la figure 5. Les électrodes supérieures 26 sont reliées par les connexions latérales 27 et les connexions électriques formées dans la couche diélectrique 18 à des plots électriques E1 du substrat 17 et les électrodes inférieures 20, 21 sont reliées à des plots électriques E2 du substrat 17.

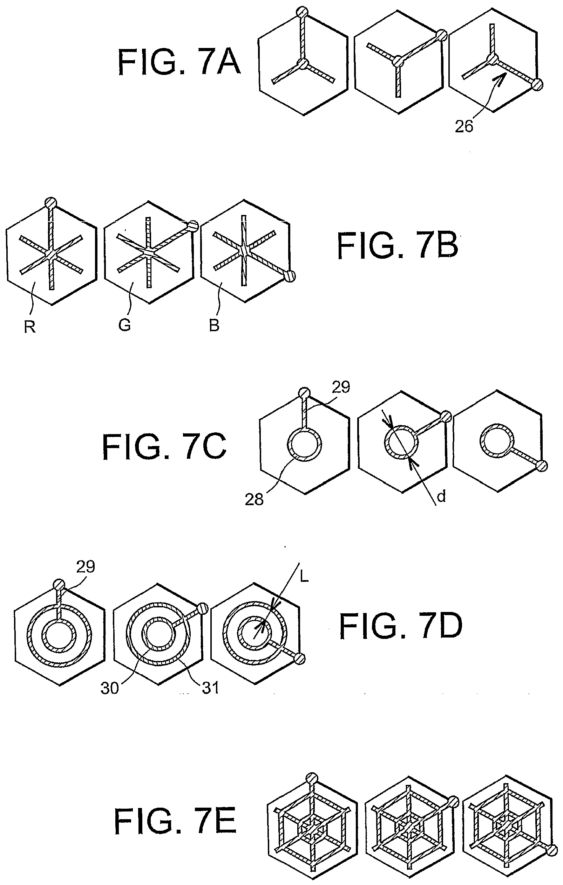

Les figures 7A-7E représentent différents exemples de géométries possibles pour l'électrode supérieure. Comme cela a déjà été mentionné précédemment, l'électrode supérieure 26 est agencée pour optimiser la collecte des porteurs tout en minimisant l'absorption optique. La largeur des pistes qui constituent l'électrode 26 est ainsi choisie à cette fin (par exemple inférieure à 0,3 µm, comme mentionné ci-dessus). Par ailleurs, les pistes sont positionnées afin de focaliser les lignes de champ vers le centre du pixel, permettant ainsi de drainer le maximum de porteurs vers le centre du pixel.

Les figures 7A et 7B représentent deux variantes d'électrodes en étoile. La figure 7A représente la variante à trois branches décrite ci-dessus. La figure 7B représente une variante à six branches, deux branches voisines faisant un angle de 60° entre elles.

Les figures 7C et 7D représentent deux variantes d'électrodes en forme de couronne. Selon la variante de la figure 7C, l'électrode 26 comprend une partie circulaire centrale 28 et une partie rectiligne 29 reliée à la partie circulaire 28. La partie rectiligne 29, située à l'extérieur de la surface délimitée par la partie circulaire 28, coupe cette dernière à angle droit.

Selon la variante de la figure 7D, l'électrode 26 comprend deux parties circulaires centrales et une partie rectiligne. Les parties circulaires centrales 30, 31 sont concentriques et toutes deux reliées à angle droit à la partie rectiligne 29. Des motifs d'électrodes comprenant plus de deux parties circulaires ou couronnes sont également possibles. De façon plus générale, en effet, la taille et le nombre de parties circulaires sont adaptés à la taille du pixel et à la longueur de diffusion des porteurs dans le matériau.

Selon l'invention, la taille de la zone semi-conductrice photosensible d'un pixel est choisie de l'ordre de quelques longueurs de diffusion des porteurs. Dans le cas représenté à la figure 7C, le diamètre d de la couronne 28 peut alors, par exemple, être égal à trois fois la longueur de diffusion des porteurs et, dans la cas de la figure 7D, les couronnes peuvent être séparées, par exemple, d'une distance L égale à trois fois la longueur de diffusion des porteurs.

La figure 7E représente une électrode en forme de toile d'araignée. L'électrode 26 comprend, par exemple, deux parties de forme hexagonale et six parties rectilignes. Les deux parties de forme hexagonale sont placées l'une dans l'autre et les six parties rectilignes sont telles que deux parties voisines font un angle de 60° l'une avec l'autre. Comme précédemment, les dimensions sont ajustées sur la longueur de diffusion des porteurs.

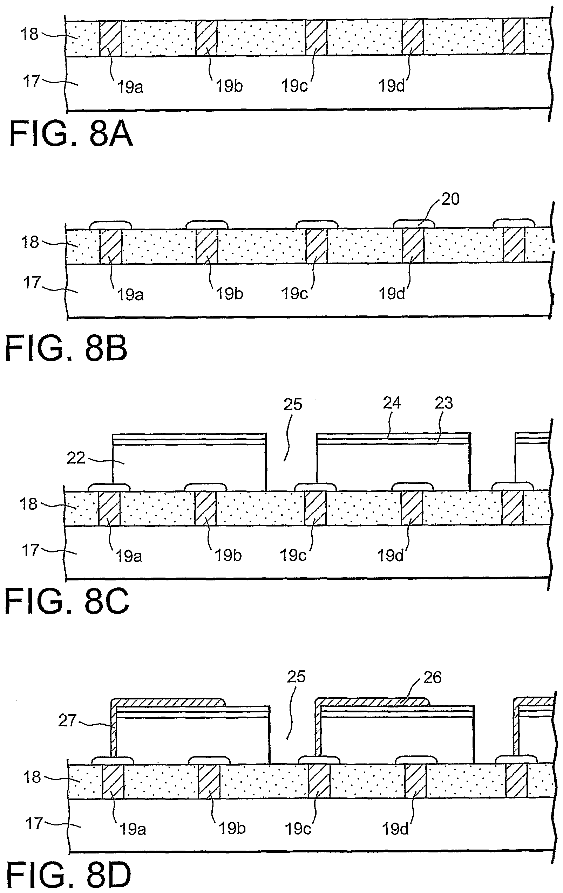

Les figures 8A-8D représentent différentes étapes d'un exemple de procédé de fabrication de dispositif photodétecteur selon l'invention. La couche de diélectrique 18 dans laquelle sont insérées les connexions électriques 19a, 19b, 19c, 19d est tout d'abord formée sur le circuit de lecture 17 (cf. figure 8A). Le circuit de lecture 17 peut indifféremment présenter une surface plane, comme illustré sur les figures 8A-8D, ou une surface non plane. Des contacts électriques (barrières de diffusion 20 et, éventuellement, contacts conducteurs 21) sont ensuite formés sur les connexions électriques 19a, 19b, 19c, 19d, afin de réaliser des électrodes (cf. figure 8B). Une couche de semi-conducteur intrinsèque, puis, éventuellement, une couche de barrière de diffusion et une couche de semi-conducteur dopé P sont ensuite déposées sur la couche diélectrique 18. Selon l'exemple de procédé représenté sur les figures 8A-8D, les couches de semi-conducteur dopé P, de barrière de diffusion et de semi-conducteur photosensible sont alors gravées pour former un ensemble de pixels séparés les uns des autres par les tranchées 25 (figure 8C). Selon d'autres modes de réalisation de l'invention (non représentés sur les figures), les couches de semi-conducteur dopé P, de barrière de diffusion et de semi-conducteur photosensible ne sont pas gravées de sorte que les pixels ne sont pas séparés par des tranchées.

Les motifs métalliques 26 sont ensuite formés à la surface des pixels et reliés, par les liaisons conductrices latérales 27, à des connexions métalliques insérées dans la couche diélectrique 18 (cf. figure 8D). La formation des électrodes de surface 26 est effectuée, tout d'abord, par dépôt d'une couche métallique, puis, par gravure de la couche métallique ainsi déposée afin de dessiner les motifs des électrodes. Les liaisons électriques latérales 27 sont formées dans les tranchées 25. Dans les cas (non représentés sur les figures) où il n'y a pas de tranchées séparant les pixels les uns des autres, les liaisons électriques latérales 27 sont réalisées selon la technique connue des trous métallisés.

Selon un mode de réalisation particulier de l'invention, des motifs métalliques 26 de plusieurs pixels voisins peuvent être reliés les uns aux autres. A titre d'exemple non limitatif, dans le cas d'une structure de pixels hexagonaux telle que représentée, par exemple, en figure 9, il est ainsi possible de relier plusieurs motifs métalliques 26 au moyen de contacts électriques C situés entre pixels voisins. Les contacts C peuvent alors être reliés à un même plot conducteur supérieur P1 alors que les électrodes inférieures 20, 21 sont reliées à un plot conducteur inférieur P2. Le fait de regrouper les électrodes de surface 26 de plusieurs pixels voisins permet d'effectuer des lissages ou filtrages d'images. Il est alors possible d'éliminer le bruit de fond continu de l'image ou de compenser les variations de performances dues aux fluctuations technologiques.

## Revendications

1. Matrice de pixels détecteurs, un pixel détecteur comprenant une zone semi-conductrice photosensible (22) ayant une première face recouverte d'une première électrode (26) et une deuxième face située à l'opposé de la première face et recouverte d'une deuxième électrode (20 ; 21), la zone semi-conductrice photosensible (22) permettant de convertir en porteurs des photons incidents sur la première face, la première électrode comprenant un motif métallique (26) apte à collecter des porteurs générés dans la zone semi-conductrice photosensible, chaque pixel détecteur étant séparé d'au moins un pixel détecteur voisin par des tranchées (25), **caractérisée en ce que** :
- la forme du motif métallique (26) est telle que tous les points de la zone semi-conductrice photosensible d'un pixel détecteur sont à une distance du motif métallique inférieure à quatre fois la longueur de diffusion des porteurs dans le matériau de la zone semi-conductrice photosensible, constituant ainsi une zone de collecte pour l'ensemble des porteurs générés dans la zone semi-conductrice photosensible

2. Matrice de pixels détecteurs selon la revendication 1, **caractérisée en ce que** les pixels détecteurs sont regroupés par blocs, un bloc de pixels détecteurs étant constitué d'une pluralité de pixels détecteurs voisins dont les motifs métalliques sont électriquement reliés entre eux.

3. Matrice de pixels détecteurs selon la revendication 1 ou 2, **caractérisée en ce que** la première face d'un pixel détecteur est en forme d'hexagone.

4. Matrice de pixels détecteurs selon l'une quelconque des revendications précédentes, **caractérisée en ce que** la forme du motif métallique (26) est adaptée pour drainer les porteurs dans une zone sensiblement centrale du pixel détecteur.

5. Matrice de pixels détecteurs selon la revendication 4, **caractérisée en ce qu'**un motif métallique (26) comprend un ensemble de pistes en forme d'étoile à plusieurs branches, le centre de l'étoile étant sensiblement placé au centre de la première face.

6. Matrice de pixels détecteurs selon la revendication 4, **caractérisée en ce qu'**un motif métallique comprend au moins une piste circulaire et au moins une piste rectiligne qui coupe la piste circulaire à angle droit, le centre de la piste circulaire étant positionné sensiblement au centre de la première face.

7. Matrice de pixels détecteurs selon la revendication 4, **caractérisée en ce qu'**un motif métallique comprend au moins une piste en forme d'hexagone sensiblement centré sur la première face et au moins une piste rectiligne passant par le centre de l'hexagone et par deux sommets de l'hexagone symétriques par rapport au centre.

8. Matrice de pixels détecteurs selon l'une quelconque des revendications 5 à 7, **caractérisée en ce que** les pistes ont une largeur sensiblement inférieure à 0,3 *µ*m.

9. Matrice de pixels détecteurs selon l'une quelconque des revendications précédentes, **caractérisé en ce que** le motif métallique (26) est en Al, ou Cu, ou Cr, ou Ni, ou W, ou Ti, ou TiW, ou Mo, ou In, ou Pt, ou Pd, ou Au, ou TiN, ou en alliage de métaux choisis parmi les métaux énumérés ci-devant.

10. Matrice de pixels détecteurs selon l'une quelconque des revendications précédentes, **caractérisée en ce que** la deuxième électrode est constituée d'un contact électrique (21) et d'une couche de barrière de diffusion (20).

11. Matrice de pixels détecteurs selon l'une quelconque des revendications précédentes, **caractérisée en ce qu'**un pixel détecteur comprend, entre la première face de la zone semi-conductrice photosensible (22) et le motif métallique (26) de la première électrode, une couche de barrière de diffusion (23) au contact de la première face et une couche (24) de semi-conducteur dopé P qui recouvre la couche de barrière de diffusion.

12. Matrice de pixels détecteurs selon l'une quelconque des revendications précédentes, **caractérisée en ce que** la zone semi-conductrice photosensible (22) est en silicium amorphe ou en silicium polymorphe.

13. Détecteur photoélectrique comprenant une matrice de pixels détecteurs et un circuit de lecture (17) de porteurs détectés par les pixels détecteurs, **caractérisé en ce que** la matrice de pixels détecteurs est une matrice selon l'une quelconque des revendications précédentes formée sur une couche diélectrique (18) dans laquelle sont insérées des connexions électriques (19a, 19b, 19c, 19d), au moins un pixel détecteur ayant le motif métallique (26) de première électrode relié, par une liaison métallique (27), à une première connexion électrique (19a, 19c) et la deuxième électrode (20 ; 21) électriquement reliée à une deuxième connexion électrique (19b ; 19d).

14. Détecteur photoélectrique selon la revendication 13, **caractérisé en ce que** la couche diélectrique (18) est directement formée sur le circuit de lecture (17).

15. Détecteur photoélectrique selon l'une des revendications 13 ou 14, **caractérisé en ce que** le circuit de lecture est un circuit CMOS.

16. Procédé de fabrication de matrice de pixels détecteurs selon la revendication 1, le procédé comprenant, pour un pixel détecteur, la réalisation de la première électrode sur la première face de la zone semi-conductrice photosensible, la première électrode comprenant la formation du motif métallique (26) destiné à collecter les porteurs générés dans la zone semi-conductrice photosensible, le procédé comprenant
- la formation du motif métallique (26) est telle que tous les points de la zone semi-conductrice photosensible d'un pixel détecteur sont à une distance du motif métallique inférieure à quatre fois la longueur de diffusion des porteurs dans le matériau de la zone semi-conductrice photosensible, constituant ainsi une zone de collecte pour l'ensemble des porteurs générés dans la zone semi-conductrice photosensible ;
- la réalisation des tranchées (25) qui séparent au moins chaque pixel détecteur d'au moins un pixel détecteur voisin.

17. Procédé selon la revendication 16, **caractérisé en ce que** le motif métallique (26) est formé pour drainer les porteurs dans une zone sensiblement centrale du pixel.

## Patentansprüche

1. Matrix aus Detektorpixeln, wobei ein Detektorpixel einen lichtempfindlichen Halbleiterbereich (22) mit einer von einer ersten Elektrode (26) überdeckten ersten Seite und einer der ersten Seite entgegengesetzten und von einer zweiten Elektrode (20; 21) überdeckten zweiten Seite aufweist, wobei der lichtempfindliche Halbleiterbereich (22) gestattet, auf die erste Seite einfallende Photonen in Ladungsträger umzuwandeln, wobei die erste Elektrode ein metallisches Muster (26) aufweist, das dazu geeignet ist, die in dem lichtempfindlichen Halbleiterbereich erzeugten Ladungsträger zu sammeln, wobei jedes Detektorpixel von zumindest einem benachbarten Detektorpixel durch Gräben (25) getrennt ist,
**dadurch gekennzeichnet, dass**
- die Form des metallischen Musters (26) derart ist, dass alle Punkte des lichtempfindlichen Halbleiterbereichs eines Detektorpixels in einem Abstand von dem metallischen Muster liegen, der geringer als die vierfache Diffusionslänge der Ladungsträger in dem Material des lichtempfindlichen Halbleiterbereichs ist, wodurch ein Sammelbereich für die Gesamtheit der in dem lichtempfindlichen Halbleiterbereich erzeugten Ladungsträger gebildet wird.

2. Matrix aus Detektorpixeln nach Anspruch 1, **dadurch gekennzeichnet, dass** die Detektorpixel blockweise zusammengefasst sind, wobei ein Block von Detektorpixeln aus einer Mehrzahl von benachbarten Detektorpixeln besteht, deren metallische Muster elektrisch miteinander verbunden sind.

3. Matrix aus Detektorpixeln nach Anspruch 1 oder 2, **dadurch gekennzeichnet, dass** die erste Seite eines Detektorpixels sechseckförmig ist.

4. Matrix aus Detektorpixeln nach einem der vorangehenden Ansprüche, **dadurch gekennzeichnet, dass** die Form des metallischen Musters (26) dazu ausgelegt ist, die Ladungsträger in einen im Wesentlichen mittigen Bereich des Detektorpixels zu führen.

5. Matrix aus Detektorpixeln nach Anspruch 4, **dadurch gekennzeichnet, dass** ein metallisches Muster (26) eine Anordnung von Bahnen in Form eines Sterns mit mehreren Zacken aufweist, wobei der Mittelpunkt des Sterns im Wesentlichen in der Mitte der ersten Seite liegt.

6. Matrix aus Detektorpixeln nach Anspruch 4, **dadurch gekennzeichnet, dass** ein metallisches Muster zumindest eine kreisförmige Bahn und zumindest eine geradlinige Bahn enthält, welche die kreisförmige Bahn im rechten Winkel schneidet, wobei der Mittelpunkt der kreisförmigen Bahn im Wesentlichen in der Mitte der ersten Seite positioniert ist.

7. Matrix aus Detektorpixeln nach Anspruch 4, **dadurch gekennzeichnet, dass** ein metallisches Muster zumindest eine sechseckförmige Bahn enthält, die im Wesentlichen auf die erste Seite zentriert ist, sowie zumindest eine geradlinige Bahn, die durch den Mittelpunkt des Sechsecks und durch zwei symmetrisch zum Mittelpunkt verlaufende Ecken des Sechsecks verläuft.

8. Matrix aus Detektorpixeln nach einem der Ansprüche 5 bis 7, **dadurch gekennzeichnet, dass** die Bahnen eine Breite im Wesentlichen von unter 0,3 µm haben.

9. Matrix aus Detektorpixeln nach einem der vorangehenden Ansprüche, **dadurch gekennzeichnet, dass** das metallische Muster (26) aus Al oder Cu oder Cr oder Ni oder W oder Ti oder TiW oder Mo oder In oder Pt oder Pd oder Au oder TiN oder aus einer Legierung aus Metallen, ausgewählt aus den aufgezählten Metallen, besteht.

10. Matrix aus Detektorpixeln nach einem der vorangehenden Ansprüche, **dadurch gekennzeichnet, dass** die zweite Elektrode aus einem elektrischen Kontakt (21) und einer Diffusionsbarriereschicht (20) besteht.

11. Matrix aus Detektorpixeln nach einem der vorangehenden Ansprüche, **dadurch gekennzeichnet, dass** ein Detektorpixel zwischen der ersten Seite des lichtempfindlichen Halbleiterbereichs (22) und dem metallischen Muster (26) der ersten Elektrode eine Diffusionsbarriereschicht (23) in Kontakt mit der ersten Seite und eine p-dotierte Halbleiterschicht (24) enthält, welche die Diffusionsbarriereschicht überdeckt.

12. Matrix aus Detektorpixeln nach einem der vorangehenden Ansprüche, **dadurch gekennzeichnet, dass** der lichtempfindliche Halbleiterbereich (22) aus amorphem Silicium oder aus polymorphem Silicium besteht.

13. Photoelektrischer Detektor mit einer Matrix aus Detektorpixeln und einer Leseschaltung (17) zum Lesen von von den Detektorpixeln detektierten Ladungsträgern, **dadurch gekennzeichnet, dass** die Matrix aus Detektorpixeln eine Matrix nach einem der vorangehenden Ansprüche ist, die aus einer dielektrischen Schicht (18) gebildet ist, in welche elektrische Verbindungen (19a, 19b, 19c, 19d) eingesetzt sind, wobei zumindest ein Detektorpixel mit dem metallischen Muster (26) der ersten Elektrode über eine metallische Verbindung (27) mit einer ersten elektrischen Verbindung (19a, 19c) verbunden ist und mit der zweiten Elektrode (20; 21) elektrisch mit einer zweiten elektrischen Verbindung (19b; 19d) verbunden ist.

14. Photoelektrischer Detektor nach Anspruch 13, **dadurch gekennzeichnet, dass** die dielektrische Schicht (18) direkt an der Leseschaltung (17) ausgebildet ist.

15. Photoelektrischer Detektor nach einem der Ansprüche 13 oder 14, **dadurch gekennzeichnet, dass** die Leseschaltung eine CMOS-Schaltung ist.

16. Verfahren zum Herstellen einer Matrix aus Detektorpixeln nach Anspruch 1, wobei das Verfahren für ein Detektorpixel das Ausbilden der ersten Elektrode an der ersten Seite des lichtempfindlichen Halbleiterbereichs umfasst, wobei die erste Elektrode die Bildung des metallischen Musters (26) aufweist, das dazu bestimmt ist, die in dem lichtempfindlichen Halbleiterbereich erzeugten Ladungsträger zu sammeln, wobei das Verfahren umfasst:
- Ausbilden des metallischen Musters (26) derart, dass alle Punkte des lichtempfindlichen Halbleiterbereichs eines Detektorpixels in einem Abstand von dem metallischen Muster liegen, der geringer als die vierfache Diffusionslänge der Ladungsträger in dem Material des lichtempfindlichen Halbleiterbereichs ist, wodurch ein Sammelbereich für die Gesamtheit der in dem lichtempfindlichen Halbleiterbereich erzeugten Ladungsträger gebildet wird;
- Ausbilden der Gräben (25), die zumindest jedes Detektorpixel von zumindest einem benachbarten Detektorpixel trennen.

17. Verfahren nach Anspruch 16, **dadurch gekennzeichnet, dass** das metallische Muster (26) ausgebildet ist, um die Ladungsträger in einen im Wesentlichen mittigen Bereich des Pixels zu führen.

## Claims

1. Matrix of detection pixels, wherein a detection pixel includes a photosensitive semi-conductor area (22) with a first face covered with a first electrode (26) and a second face located opposite the first face and covered with a second electrode (20 ; 21), wherein the photosensitive semi-conductor area (22) allows converting the photons incident on the first phase into charge carriers, wherein the first electrode includes a metal pattern (26) adapted to collect the charge carriers generated in the photosensitive semi-conductor area, and each pixel being separated from at least one neighbouring detection pixel by trenches (25), **characterised in that** :
- the shape of the metal pattern (26) is such that all the points of the photosensitive semi-conductor area of a detection pixel are at a distance from the metal pattern which is less than four times the diffusion length of the charge carriers in the material of the photosensitive semi-conductor area, thereby constituting a collection area for all the charge carriers generated in the photosensitive semi-conductor area

2. Matrix of detection pixels according to claim 1, **characterised in that** the detection pixels are grouped into blocks, a block of detection pixels being composed of a plurality of neighbouring detection pixels whose metal patterns are electrically linked to each other.

3. Matrix of detection pixels according to claim 1 or 2, **characterised in that** the first face of a detection pixel is in the shape of a hexagon.

4. Matrix of detection pixels according to any of the previous claims, **characterised in that** the shape of the metal pattern (26) is adapted to drain the charge carriers in a substantially central area of the detection pixel.

5. Matrix of detection pixels according to claim 4, **characterised in that** a metal pattern (26) includes a set of tracks in the shape of star with several branches, the centre of the star being placed substantially in the centre of the first face.

6. Matrix of detection pixels according to claim 4, **characterised in that** a metal pattern includes at least one circular track and at least one straight-line track that cuts the circular track at a right angle, the centre of the circular track being placed substantially at the centre of the first face.

7. Matrix of detection pixels according to claim 4, **characterised in that** a metal pattern includes at least one track in the form of a hexagon that is substantially centred on the first face and at least one straight-line track that passes through the centre of the hexagon and through two peaks of the hexagon that are symmetrical with respect to the centre.

8. Matrix of detection pixels according to any of claims 5 to 7, **characterised in that** the tracks have a width that is substantially less than 0.3 µm.

9. Matrix of detection pixels according to any of the previous claims, **characterised in that** the metal pattern (26) is in Al, Cu, Cr, Ni, W, Ti, TiW, Mo, In, Pt, Pd, Au, TiN, or in an alloy of metals chosen from the previously mentioned metals.

10. Matrix of detection pixels according to any of the previous claims, **characterised in that** the second electrode is composed of an electrical contact (21) and a diffusion barrier layer (20).

11. Matrix of detection pixels according to any of the previous claims, **characterised in that** a detection pixel includes, between the first face of the photosensitive semi-conductor area (22) and the metal pattern (26) of the first electrode, a diffusion barrier layer (23) in contact with the first face and a doped P semi-conductor layer (24) that covers the diffusion barrier layer.

12. Matrix of detection pixels according to any of the previous claims, **characterised in that** the photosensitive semi-conductor area (22) is in amorphous silicon or polymorphous silicon.

13. Photoelectric detector that includes a matrix of detection pixels and a reading circuit (17) for reading charge carriers detected by the detection pixels, **characterised in that** the matrix of detection pixels is a matrix according to any of the previous claims, formed on a dielectric layer (18) in which electrical connections (19a, 19b, 19c, 19d) are inserted, at least one detection pixel having the metal pattern (26) of the first electrode connected, using a metal link (27), to a first electrical connection (19a, 19c) and the second electrode (20 ; 21) electrically linked to a second electrical connection (19b ;19d).

14. Photoelectric detector according to claim 13, **characterised in that** the dielectric layer (18) is formed directly on the reading circuit (17).

15. Photoelectric detector according to claims 13 or 14, **characterised in that** the reading circuit is a CMOS circuit.

16. Method for manufacturing a matrix of detection pixels according to claim 1, the method comprising, for a detection pixel, the creation of the first electrode on the first face of the photosensitive semi-conductor area, wherein the first electrode includes the formation of the metal pattern (26) intended to collect the charge carriers generated in the photosensitive semi-conductor area, the method comprising:
- the formation of the metal pattern (26) is such that all the points of the photosensitive semi-conductor area of a detection pixel are at a distance from the metal pattern which is less than four times the diffusion length of the charge carriers in the material of the photosensitive semi-conductor area, thereby constituting a collection area for all the charge carriers generated in the photosensitive semi-conductor area;
- the creation of the trenches (25) that separate at least one detection pixel from at least one neighbouring detection pixel.

17. Method according to claim 16, **characterised in that** the metal pattern (26) is formed to drain the charge carriers in a substantially central area of the pixel.
